# EUROPÄISCHE PATENTANMELDUNG

(11) **EP 2 467 000 A1**
(43) Veröffentlichungstag der Anmeldung: **20.06.2012**
(21) Anmeldenummer: 11193939.3
(22) Anmeldetag: 16.12.2011
(51) Int. Cl.: H05K 1/03, H05K 3/28, H05K 3/34, C03C 17/32, C09D 5/20

(54) **Formkörper mit einem Substrat mit ablösbarer Schutzlackschicht sowie Verfahren zu seiner Herstellung**

(30) Priorität: 16.12.2010 DE 102010063308
(71) Anmelder: Irlbacher Blickpunkt Glas GmbH, 92539 Schönsee (DE)
(72) Erfinder: Irlbacher, Günther, 92539 Schönsee (DE)
(74) Vertreter: Hinkelmann, Klaus

(57) **Zusammenfassung**

Die Erfindung betrifft einen Formkörper 1, umfassend ein Substrat 2 aus einem Metall, Glas, Glaskeramik oder Keramik mit einer ersten Oberfläche 4 und einer zweiten Oberfläche 5, wobei das Substrat auf mindestens einem Teil seiner ersten und/oder zweiten Oberfläche 4,5 eine Schutzschicht aufweist, die eine ablösbare Schutzlackschicht 6 ist. Die Erfindung betrifft außerdem ein Verfahren zur Herstellung des Formkörpers 2.

## Beschreibung

Die Erfindung betrifft einen Formkörper mit einem Substrat mit einer ablösbaren Schutzlackschicht sowie ein bevorzugtes Verfahren zu dessen Herstellung.

Bei der Weiterverarbeitung von Substraten, die z.B. aus Metall, Glas, Glaskeramik oder Keramik bestehen, werden häufig an einem Teil der Oberfläche mehrere Bearbeitungsschritte durchgeführt, um dem Substrat bestimmte Eigenschaften oder Funktionen zu verleihen.

Beispielsweise ist es bekannt, Glas als Substrat für Bedienfelder (Bedienpanele) in Haushaltgeräten sowie in Geräten der Unterhaltungselektronik einzusetzen. Bei diesen Bedienfeldern sind auf einem Substrat aus Glas bestimmte Bedienungselemente angeordnet, die der Auswahl und Steuerung von Funktionen des zu bedienenden Gerätes dienen. Zur Herstellung werden diese Substrate auf einer einem Benutzer zugewandten Seite sowie auf einer dem Benutzer abgewandten Seite bestimmten Bearbeitungsschritten unterzogen. Beispielsweise können berührungsempfindliche Sensoren angebracht werden, bei denen am Ort des Sensors auf der dem Benutzer zugewandten Seite ein oder mehrere Bereiche mit einer bestimmten Oberflächenbeschaffenheit (Griffmulden, Bereiche unterschiedlicher Oberflächenrauheit, Farbe, usw.) vorgesehen sind. Die Bearbeitung von solchen Substraten ist also häufig auf bestimmte Bereiche der Oberflächen beschränkt. Andererseits werden auf einer dem Benutzer abgewandten Seite solcher Glassubstrate (Glasscheiben) häufig ein oder mehrere Farbschichten aufgetragen, wobei je nach gewünschtem Zweck bestimmte Bereiche so ausgestaltet sind, dass sie transparent oder transluzent sind. In diesen Fällen sind hinter der Glasscheibe häufig eine Beleuchtungseinheit und/oder ein Display zur Anzeige bestimmter Symbole oder Buchstaben angeordnet.

Bei der Herstellung durchlaufen derartige Bedienpanele somit mehrere Bearbeitungsschritte. So wird auf die erste Oberfläche eines dielektrischen Substrates im Allgemeinen nicht nur eine Leiterschicht, sondern zusätzliche Schichten, z.B. Farbschichten aufgebracht. Anschließend erfolgt zur Herstellung der Bedienpanele im Allgemeinen noch eine Bestückung mit elektronischen Bauteilen. Die Bestückung und Befestigung (z.B. durch Löten) mit elektronischen Bauteilen erfolgen häufig örtlich getrennt von der Beschichtung des dielekrischen Substrats. Wünschenswert wäre es jedenfalls, wenn die zweite Oberfläche des Substrates während dieser Bearbeitungsschritte und/oder nach Durchführung der Herstellungsschritte vor mechanischen oder chemischen Einwirkungen geschützt werden könnte.

Jedenfalls kann es bei der Bearbeitung von Glassubstraten aber auch von anderen Substraten, durch Stoß, Berührung mit scharfen Gegenständen usw. zu Beschädigungen kommen, die entweder zu zeit- oder kostenaufwändigen Reparaturen, zu dauerhaften Schädigungen oder bei gravierenden Beschädigungen sogar zu einem vollständigen Verlust des Formkörpers führen.

Die DE 10 2005 013 884 A1 und die EP 1 705 163 A1 beschreiben ein Bedienpanel mit einem planen oder gebogenen Basiskörper aus einem dielektrischen Werkstoff wie Glas, Glaskeramik oder Keramik, der rückseitig mit mindestens einer Schicht aus einbrennbarer Farbe, wie Glasemail- oder Keramikfarbe und mindestens einer Schicht von Leiterstrukturen aus einbrennbarer Leitpaste bedruckt ist, wobei die Leiterstrukturen zur Aufnahme von mindestens einem elektronischen Bauteil ausgebildet sind, und wobei mehrere Schichten aus einbrennbarer Farbe auf dem Basiskörper angebracht sind. Das Bedienpanel ist erhältlich durch Einbrennen der Farbe und der Leitpaste in einem Arbeitsgang, wobei die Farbe und die Leitpaste im Wesentlichen die gleiche Einbrenntemperatur haben. Die Leiterstrukturen umfassen mindestens ein Sensorelement.

Die DE 10 2005 054 562 A1 beschreibt einen photostrukturierbaren Lötstopplack, der mindestens ein Pulverlackharz enthält, sowie dessen Verwendung für Leiterplatten.

Die EP 1 487 759 B1 beschreibt ein Verfahren zum Herstellen eines Metall-Keramik-Substrats, bei dem auf die Oberflächenseite einer Keramikschicht oder eines Keramik-Substrates mit Hilfe eines Hochtemperatur-Bonding-Verfahrens jeweils wenigstens eine Metall-Folie aufgebracht wird und die Metall-Folie an wenigstens einer Oberflächenseite zur Bildung von Leiterbahnen, Kontaktflächen und dergleichen strukturiert wird, wobei auf die Metallfläche wenigstens einer Metallfolie oder wenigstens einer Metallisierung zumindest ein Auftrag aus einem Lötstopplack aufgebracht wird.

Aufgabe der Erfindung war es vor diesem Hintergrund, einen Formkörper, umfassend ein Substrat aus einem Metall, Glas, Glaskeramik oder Keramik, bereitzustellen, bei dem das Substrat bei seiner Bearbeitung hinsichtlich Beschädigungen seiner Oberfläche geschützt ist und bei dem dieser Schutz die spätere Verwendung des Formkörper nicht beeinträchtigt. Aufgabe der Erfindung war außerdem die Bereitstellung eines Verfahrens zu seiner Herstellung.

Die Lösung dieser Aufgabe wird nach dieser Erfindung erreicht durch einen Formkörper sowie ein Verfahren zu seiner Herstellung mit den Merkmalen der entsprechenden unabhängigen Patentansprüche. Bevorzugte Ausführungsformen des erfindungsgemäßen Formkörpers sind in entsprechenden abhängigen Patentansprüchen aufgeführt. Bevorzugten Ausführungsformen des erfindungsgemäßen Formkörpers entsprechen bevorzugte Ausführungsformen des erfindungsgemäßen Verfahrens und umgekehrt, selbst wenn dies hierin nicht explizit festgestellt wird.

Gegenstand der Erfindung ist somit ein Formkörper, umfassend ein Substrat aus einem Metall, Glas, Glaskeramik oder Keramik mit einer ersten Oberfläche und einer zweiten Oberfläche, wobei das Substrat auf mindestens einem Teil seiner ersten und/oder zweiten Oberfläche eine Schutzschicht aufweist, welche eine ablösbare Schutzlackschicht ist.

"Ablösbare Schutzlackschicht" im Sinne der Erfindung bedeutet, dass die Schutzlackschicht vom Substrat entfernt werden kann, ohne dass hierdurch das Substrat beschädigt wird. Vorzugsweise kann die Schutzlackschicht mechanisch, insbesondere durch Abziehen durch einen Benutzer abgelöst werden.

Der Begriff "Schutzlackschicht" bedeutet insbesondere eine Schicht aus einem gehärteten Lack. Der Begriff "Lack", wie er hierin verwendet wird, bedeutet dagegen im Allgemeinen eine noch fließfähige Zusammensetzung, die auf das Substrat zur Erzeugung der Schutzlackschicht aufgebracht werden kann.

Das Substrat im Sinne der vorliegenden Erfindung ist vorzugsweise ein dielektrisches Substrat wie z.B. Glas, Glaskeramik oder Glas. Bevorzugt ist das Substrat Glas, insbesondere eine Glasplatte, im Allgemeinen eine Floatglasplatte. Ganz besonders bevorzugt besteht das Substrat aus Einscheibensicherheitsglas. Dann ist der Formkörper besonders bruchfest und auch bei hohen Temperaturen noch stabil.

In einer bevorzugten Ausführungsform des erfindungsgemäßen Formkörpers ist der Schutzlack der Schutzlackschicht ein durch Einwirkung von Wärme und/oder Strahlung gehärteter Lack, wobei der Lack eine härtbare, insbesondere durch Einwirkung von Wärme oder Licht, Zusammensetzung aus polymerisierbaren Monomeren und/oder vernetzbaren Oligomeren und/oder Polymeren umfasst. Hierbei ist es bevorzugt, dass die härtbare Zusammensetzung einen Feststoffgehalt von mindestens 90 % aufweist.

Der Formkörper ist erfindungsgemäß nicht besonders beschränkt, da bei zahlreichen Formkörpern häufig ein Substrat in Hinblick auf eine mögliche Beschädigung zu schützen ist.

Besonders bevorzugt umfasst der Formkörper ein Bedienpanel, welches wiederum vorzugsweise ein dielektrisches Substrat aus Glas, Glaskeramik oder Keramik mit einer ersten Oberfläche und einer zweiten Oberfläche umfasst, wobei eine Schicht mit Leiterstrukturen auf der ersten Oberfläche und eine abziehbare Schutzlackschicht auf der zweiten Oberfläche angeordnet ist. Hierbei weist das Bedienpanel vorzugsweise einen berührungsempfindlichen Sensor auf. Erfindungsgemäß sind als berührungsempfindliche Sensoren kapazitive Sensoren bevorzugt. Überdies ist es bevorzugt, dass zwischen der Schicht mit Leiterstrukturen auf der ersten Oberfläche des Substrats und dem Substrat mindestens eine Schicht aus einem Farblack angeordnet ist.

Bei Bedienpanelen befinden sich im Allgemeinen sämtliche Leiterstrukturen, Lötverbindungen und elektronischen Bauteile, und ggf. weitere Komponenten auf einer dem Benutzer des Bedienpanels abgewandten Seite des Substrates.

Beim erfindungsgemäßen Formkörper ist vorzugsweise eine Abziehhilfe angebracht. Die Abziehhilfe ist vorzugsweise eine Lasche, die von einem Benutzer ergriffen werden kann, der dadurch den Schutzlack vom Substrat abziehen kann. Die Lasche sollte ausreichend stabil sein, um von einem Benutzer gegriffen werden zu können. Ansonsten ist die Abziehhilfe möglichst dünn, wobei die Dicke von der Natur des gewählten Materials und der gewünschten Steifigkeit der Abziehhilfe abhängt. Als Material der Abziehhilfe wird vorzugsweise ein Kunststoff, insbesondere ein thermoplastischer Kunststoff gewählt, beispielsweise aus Polypropylen.

Eine an der Schutzlackschicht angebrachte Abziehhilfe kann sich innerhalb des Schutzlackes aber auch zwischen Substrat und Schutzlack befinden.

Die Schutzschicht hat im Allgemeinen eine Dicke von 0,05 bis 0,5 mm.

In einer besonders bevorzugten Ausführungsform des Formkörpers umfasst die ablösbare Schutzlackschicht einen Lötabdecklack oder besteht aus diesem.

Gegenstand der Erfindung ist außerdem ein Verfahren zur Herstellung eines Formkörpers, der ein Substrat aus einem Metall, Glas, Glaskeramik oder Keramik mit einer ersten Oberfläche und einer zweiten Oberfläche umfasst, wobei das Substrat auf mindestens einem Teil seiner ersten und/oder zweiten Oberfläche eine ablösbare Schutzlackschicht aufweist, umfassend die Schritte
(a) Aufbringen eines Lackes, wobei der Lack eine durch Einwirkung von Wärme und/oder Strahlung härtbare Zusammensetzung aus polymerisierbaren Monomeren und/oder vernetzbaren Oligomeren und/oder Polymeren umfasst, auf zumindest einen Teil einer ersten Oberfläche und/oder einer zweite Oberfläche des Substrats; und
(b) Härten des Lackes durch Einwirkung von Wärme und/oder Strahlung.

In einer bevorzugten Ausführungsform dieses Verfahrens wird der Lack mittels Siebdruck auf der ersten und/oder zweiten Oberfläche aufgebracht.

Der härtbare Lack weist vorzugsweise einen Feststoffgehalt von mindestens 90 % auf, und weist besonders bevorzugt einen Feststoffgehalt von mindestens 95 % auf, bezogen auf die Gesamtmasse des Lackes, gemäß DIN EN ISO 3251 (1 h, 125°C, 1g Einwaage).

Der härtbare Lack weist vorzugsweise ein wässriges Lösungsmittel auf. Insbesondere enthält der härtbare Lack vorzugsweise keine organischen Lösungsmittel.

Darüberhinaus liegt eine Viskosität des härtbaren Lackes gemäß DIN EN ISO 3219 bei 20°C vorzugsweise in einem Bereich von 10000 bis 80000 mPas. Diese Viskosität kann beispielsweise mit einem Viskositätsmeßgerät Haake RS 600, C 20/1 °, D = 50 s-1 der Firma Electron GmbH gemessen werden.

Vorzugsweise ist der härtbare Lack thixotrop.

Im Allgemeinen umfasst der Schutzlack einen durch Wärme- und/oder Strahleneinwirkung gehärteten Lack, wobei der Lack eine Zusammensetzung aus polymerisierbaren Monomeren und/oder vernetzbaren Oligomeren und/oder Polymeren ist. Der Schutzlack umfasst vorzugsweise Epoxidharze, Polybutadiene, Polyurethane, insbesondere mit Carboxyl- oder Hydroxylendgruppen, sowie deren Mischungen und Reaktionsprodukte.

Der im Formkörper, z.B. Bedienpanel, eingesetzte härtbare Lack ist vorzugsweise ein Lötabdecklack. Vorzugsweise wird hierbei ein Lötabdecklack mit einer hohen Wärmestabilität eingesetzt. Dies ermöglicht auch mehrfache Temperaturbelastungen sowie den Einsatz in Verbindung mit bleifreien Lötprozessen. Insbesondere ist die Wärmestabilität vorzugsweise so hoch, dass auch ein Reflow-Löten möglich ist.

Besonders geeignete Schutzlacke sind die Lötabdecklacke der Reihe SD 2950 der Firma Lackwerke Peters GmbH + Co KG.

Bei Verwendung eines dielektrischen Substrats ist dieses vorzugsweise transparent oder semitransparent. Ein Farbaufdruck auf der ersten Seite ist dann vorzugsweise erkennbar.

Die Erfindung hat zahlreiche Vorteile. So wird ein Formkörper, der ein Substrat umfasst, beispielsweise aus einem Metall, aber insbesondere aus einem dielektrischen Material wie Glas, Glaskeramik und Keramik, vor Beschädigungen oder sonstigen Beeinträchtigungen der Oberfläche des Substrats geschützt. So kann gemäß der Erfindung beispielsweise ein Bedienpanel bereitgestellt werden, bei dem das dielektrische Substrat während und nach der Herstellung des Bedienpanels geschützt wird. Die vorliegende Erfindung ermöglicht aber den Schutz sowohl von einfachen Formkörpern, z.B. von Glasscheiben, die weder bedruckt noch mit elektronischen Elementen bestückt sind, als auch von komplexen Formkörpern, die beispielsweise Sensoren und elektronische Schaltkreise enthalten und auch mit Farblacken bedruckt sein können.

Die Erfindung wird im Folgenden anhand zweier nicht einschränkend gemeinter Ausführungsbeispiele für einen erfindungsgemäßen Formkörper illustriert.
Fig. 1 zeigt einen Querschnitt durch einen erfindungsgemäßen Formkörper gemäß einer ersten Ausführungsform der Erfindung, welcher hier ein Bedienpanel ist.
Fig. 2 zeigt eine Draufsicht auf einen erfindungsgemäßen Formkörper gemäß einer zweiten Ausführungsform der Erfindung, welches hier ebenfalls ein Bedienpanel ist.

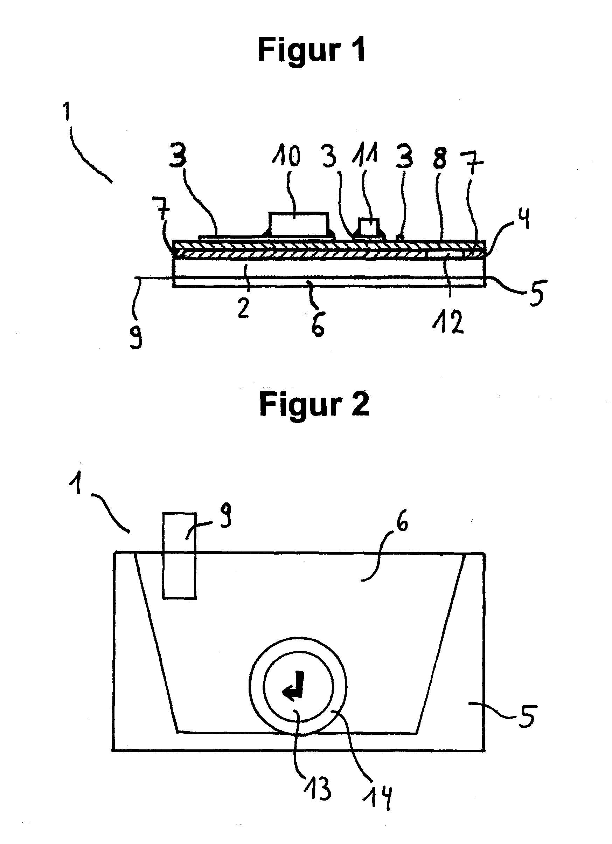

In der Figur 1 ist ein Querschnitt durch eine nicht einschränkend gemeinte Ausführungsform eines erfindungsgemäßen Formkörpers, hier eines Bedienpanels 1, gezeigt. Im Bedienpanel 1 ist auf einer ersten Seite (Vorderseite) 4 einer Glasscheibe 2 als Substrat eine Schutzlackschicht 6 aus einem gehärteten Lack aufgebracht. Zwischen der Glasscheibe 1 und der Schutzlackschicht 6 ist als Abziehhilfe 9 für die gehärtete Schutzlackschicht 6 eine Lasche aus einem Kunststoff, hier Polypropylen, aufgebracht.

Auf der zweiten Seite (Rückseite) von Substrat 2 sind zwei Farbschichten 7 und 8 aufgebracht, die Aussparungen 12 aufweisen können. Auf den Farbschichten 7 und 8 sind Leiterstrukturschichten 3 angeordnet, an denen elektronische Bauteile 10, insbesondere ein druckempfindlicher Sensor 11, befestigt sein können, beispielsweise über eine Lötverbindung.

Zur Durchführung des erfindungsgemäßen Verfahrens wird bei der hier gezeigten nicht einschränkend gemeinten Ausführungsform in einem ersten Schritt das Substrat 2, welches in der Figur 1 eine Glasplatte ist, bereitgestellt. Danach wird mittels Siebdruck auf die Rückseite, d.h. erste Oberfläche, des Substrats zunächst eine Schicht 8 und anschließend eine Schicht 9 aufgebracht. Dabei ist es auch möglich, dass bestimmte Bereiche der Rückseite von Substrat 2 nicht beschichtet werden.

Bei der hier gezeigten vorteilhaften Ausführungsform der Erfindung erfolgt nach dem Aufbringen einer Farbschicht 8 oder 9 jeweils ein Zwischentrockenschritt bei etwa 100 bis 150°C.

Danach wird mittels Siebdruck mindestens eine Schicht von Leiterstrukturen aus einbrennbarer Leitpaste 3 auf die Rückseite von Substrat 2, d.h. auf das Substrat 2 oder auf die Farbschicht 7 oder 8, aufgetragen. Leiterstrukturen umfassen elektronische Elemente wie Widerstände oder Sensorelemente. Nach dem Aufbringen aller Farbschichten 7 und 8 und der Leitpaste für die Bildung der Leiterstrukturschicht 3 erfolgt das Einbrennen dieser Schichten in einem Schritt. Die Einbrenntemperatur liegt dabei im Bereich von 600 bis 700°C und beträgt vorzugsweise etwa 620°C.

Alle Beschichtungen und weitere Komponenten wie elektronische Bauteile oder Anschlüsse sind auf der ersten Oberfläche des Substrats angebracht, so dass die zweite Oberfläche eine geschlossene Oberfläche bildet.

Fig. 2 zeigt eine Draufsicht auf einen erfindungsgemäßen Formkörper gemäß einer zweiten Ausführungsform der Erfindung, welches hier ebenfalls ein Bedienpanel ist.

Auf der dem Benutzer des Bedienpanels zugewandten zweiten Oberfläche 5 des Substrats 2 ist teilweise eine abziehbare Schutzlackschicht 6 aufgebracht. Zur leichteren Entfernbarkeit von Schutzlackschicht 6 ist zwischen der abziehbaren Schutzlackschicht 6 und der zweiten Oberfläche 5 eine Lasche als Abziehhilfe 9 aufgebracht. Die Schutzlackschicht 6 ist um ausgesparte Bereiche 13 und 14 auf der zweiten Oberfläche 5 angeordnet. An diesen Stellen war es aufgrund des nichtvorhandenen Schutzlackes möglich, die zweite Oberfläche 5 von Substrat 2 zu bearbeiten, ohne dass weitere Bereiche der zweiten Oberfläche beschädigt wurden. Bei der hier gezeigten Ausführungsform ist der erste Bereich 13 ein Funktionsauswahlbereich entsprechend einer oberen Hierarchieebene und der zweite Bereich 14 ein spezifischer Auswahlbereich entsprechend einer unteren Hierarchieebene. D.h., dass ein Benutzer durch Berühren des ersten Bereiches 13 eine Funktion auswählen kann, wobei durch Berühren bzw. durch Ziehen eines Fingers über den zweiten Bereich 14 die Funktion näher ausgestaltet werden kann (Untermenü; Intensität). Bei der hier gezeigten Ausführungsform unterscheiden sich die Oberflächen der Bereiche 13 und 14, wobei der Bereich 14 hier mattiert ausgestaltet ist und außerdem zur leichteren Aufnahme eines Fingers leicht vertieft ausgebildet sein kann.

### Bezugszeichenliste

- 1: Formkörper, hier Bedienpanel
- 2: Substrat, hier Glasscheibe
- 3: Leiterstruktur
- 4: Erste Oberfläche des Substrats
- 5: Zweite Oberfläche des Substrats
- 6: Schutzlackschicht
- 7: Erste Farbschicht
- 8: Zweite Farbschicht
- 9: Abziehhilfe, Lasche
- 10: Elektronisches Bauelement
- 11: Berührungsempfindlicher (druckempfindlicher) Sensor
- 12: Aussparung
- 13: Funktionsauswahlbereich (obere Hierarchieebene)
- 14: Spezifischer Auswahlbereich (untere Hierarchieebene)

## Patentansprüche

1. Formkörper (1), umfassend ein Substrat (2) aus einem Metall, Glas, Glaskeramik oder Keramik mit einer ersten Oberfläche (4) und einer zweiten Oberfläche (5), wobei das Substrat auf mindestens einem Teil seiner ersten und/oder zweiten Oberfläche (4,5) eine Schutzschicht aufweist, **dadurch gekennzeichnet, dass** die Schutzschicht einen ablösbare Schutzlackschicht (6) ist.

2. Formkörper (1) nach Anspruch 1, **dadurch gekennzeichnet, dass** das Substrat (2) Glas ist.

3. Formkörper (1) nach Anspruch 1 oder 2, **dadurch gekennzeichnet, dass** der Schutzlack der Schutzlackschicht (6) ein durch Einwirkung von Wärme und/oder Strahlung gehärteter Lack ist, wobei der Lack eine härtbare Zusammensetzung aus polymerisierbaren Monomeren und/oder vernetzbaren Oligomeren und/oder Polymeren umfasst.

4. Formkörper (1) nach Anspruch 3, **dadurch gekennzeichnet, dass** die härtbare Zusammensetzung einen Feststoffgehalt von mindestens 90 % aufweist.

5. Formkörper (1) nach einem der Ansprüche 1 bis 4, **dadurch gekennzeichnet, dass** der Formkörper ein Bedienpanel (1) umfasst.

6. Formkörper (1) nach Anspruch 5, **dadurch gekennzeichnet, dass** das Bedienpanel (1) ein dielektrisches Substrat (2) aus Glas, Glaskeramik oder Keramik mit einer ersten Oberfläche (4) und einer zweiten Oberfläche (5) umfasst, wobei eine Schicht mit Leiterstrukturen (3) auf der ersten Oberfläche (4) und eine abziehbare Schutzlackschicht (6) auf der zweiten Oberfläche (5) angeordnet ist.

7. Formkörper (1) nach Anspruch 5 oder 6, **dadurch gekennzeichnet, dass** das Bedienpanel (1) einen berührungsempfindlichen Sensor (11) aufweist.

8. Formkörper (1) nach einem der Ansprüche 5 bis 7, **dadurch gekennzeichnet, dass** zwischen der Schicht mit Leiterstrukturen (3) auf der ersten Oberfläche (4) des Substrats (2) und dem Substrat (2) mindestens eine Schicht (7,8) aus einem Farblack angeordnet ist.

9. Formkörper (1) nach einem der Ansprüche 1 bis 8, **dadurch gekennzeichnet, dass** an der ablösbaren Schutzlackschicht (6) eine Abziehhilfe (9) angebracht ist.

10. Formkörper (1) nach einem der Ansprüche 1 bis 9, **dadurch gekennzeichnet, dass** die ablösbare Schutzlackschicht (6) einen Lötabdecklack umfasst oder aus ihm besteht.

11. Verfahren zur Herstellung eines Formkörpers (1), der ein Substrat (2) aus einem Metall, Glas, Glaskeramik oder Keramik mit einer ersten Oberfläche (4) und einer zweiten Oberfläche (5) umfasst, wobei das Substrat auf mindestens einem Teil seiner ersten und/oder zweiten Oberfläche (4,5) eine ablösbare Schutzlackschicht (6) aufweist, umfassend die Schritte
(c) Aufbringen eines Lackes, wobei der Lack eine durch Einwirkung von Wärme oder Strahlung härtbare Zusammensetzung aus polymerisierbaren Monomeren und/oder vernetzbaren Oligomeren und/oder Polymeren umfasst, auf zumindest einen Teil einer ersten Oberfläche (4) und/oder einer zweite Oberfläche (5) des Substrats (2); und
(d) Härten des Lackes durch Einwirkung von Wärme oder Strahlung.

12. Verfahren nach Anspruch 11, **dadurch gekennzeichnet, dass** der Lack mittels Siebdruck auf der ersten und/oder zweiten Oberfläche (4,5) aufgebracht wird.
